# EUROPÄISCHE PATENTSCHRIFT

(11) **EP 2 030 492 B1**
(45) Veröffentlichungstag und Bekanntmachung des Hinweises auf die Patenterteilung: **14.03.2012**
(21) Anmeldenummer: 07726119.6
(22) Anmeldetag: 21.06.2007
(51) Int. Cl.: H05K 3/12

(54) **VERFAHREN ZUR HERSTELLUNG EINES SCHALTUNGSTEILS AUF EINEM SUBSTRAT, PLATINE UND KOMPOSITBAUTEIL**
METHOD FOR PRODUCING A CIRCUIT PART ON A SUBSTRATE, PRINTED CIRCUIT BOARD AND COMPOSITE ASSEMBLY
PROCÉDÉ DE PRODUCTION D'UNE PORTION DE CIRCUIT SUR UN SUBSTRAT, PLATINE ET ASSEMBLAGE COMPOSITE

(30) Priorität: 21.06.2006 DE 102006028536
(43) Veröffentlichungstag der Anmeldung: 04.03.2009
(73) Patentinhaber: Ahnert, Axel, 85737 Ismaning (DE); Grandy, Elmar, 85764 Oberschleissheim (DE)
(72) Erfinder: Ahnert, Axel, 85737 Ismaning (DE); Grandy, Elmar, 85764 Oberschleissheim (DE)
(74) Vertreter: Strasser, Wolfgang
(86) Internationale Anmeldenummer: PCT/EP2007/005489
(87) Internationale Veröffentlichungsnummer: WO 2007/147602

(56) Entgegenhaltungen:
- EP-A- 1 841 301
- WO-A-92/20489
- WO-A-03/032084
- WO-A-2006/112101
- WO-A-2006/133761
- FR-A- 2 321 817
- GB-A- 854 449
- JP-A- 2002 151 828

## Beschreibung

Die Erfindung betrifft ein Laserdruckverfahren zum Herstellen mindestens eines Schaltungsteils auf einem Substrat. Gemäß weiteren Aspekten betrifft die Erfindung eine Platine mit mindestens einem Schaltungsteil und ein Kompositbauteil mit mehreren Platinen.

Allgemein bekannte Verfahren zum Herstellen von Leiterbahnen einer vorgegebenen Leiterbahnstruktur auf einem Substrat basieren beispielsweise auf der nasschemischen-photolithographischen oder mechanischen Bearbeitung von kupferplatiniertem, ggf. einseitig lichtempfindlichem Basismaterial, das z. B. aus Hartpapier oder Epoxidharz hergestellt ist.

Nachteilig an dem photolithographischen Verfahren ist, dass zahlreiche verschiedene Prozessschritte notwendig sind und bei einer Einzelherstellung insbesondere durch das Ätzen Ungenauigkeiten der Leiterbahnstruktur verursacht werden können. So können je nach Ätzdauer die Leiterbahnen an den Rändern angegriffen werden. Durch die ätzbedingten Ungenauigkeiten ist die Mindestbreite einer Leiterbahn nach unten limitiert und ein Mindestabstand der Bahnen voneinander notwendig. Auch bei der mechanischen Bearbeitung, z. B. durch Fräsen des Basismaterials treten unerwünschte Ungenauigkeiten auf. Die bei den herkömmlichen Techniken beschränkte Strukturierungsgenauigkeit stellt speziell bei der Herstellung mehrschichtiger Platinen (Multilayer) ein Problem dar, da dort ein möglichst exaktes Übereinanderschichten der einzelnen Leiterbahnenstrukturen gegeben sein muss. Nachteilig an dem photolithographischen Verfahren ist ferner, dass nasschemische Schritte notwendig sind. Hierdurch fallen zu entsorgende Reststoffe an, was die Umwelt belastet und teuer ist.

Zur Vermeidung dieser Probleme wird in der nicht vorveröffentlichten EP 1 841 301 A2 vorgeschlagen, gedruckte elektrische Schaltungen mit Hilfe eines Laserdruckverfahrens herzustellen.

Ein solches Verfahren umfasst prinzipiell die Schritte: Deponieren mindestens eines elektrisch leitfähigen Granulats auf einem Substrat und Erhitzen des Granulats derart, dass das Granulat eine dauerhafte Verbindung mit dem Substrat eingeht und mindestens ein Schaltungsteil auf dem Substrat bildet. Das Granulat wird auf dem Substrat mit einer vorbestimmten geometrischen Verteilung deponiert, die der geometrischen Form des gewünschten Schaltungsteils oder von dessen Bestandteilen entspricht. Durch das Erhitzen des Granulats verschmilzt das Granulat mit sich selbst. Es soll ohne eine Veränderung der geometrischen Verteilung ein verschmolzenes Gefüge entstehen, das mit dem Substrat verbunden ist. Letzteres besteht aus einem elektrisch isolierenden Material, das durch Wärme erweichbar ist, so dass das Schaltungsteil in die Oberfläche des Substrats eingebettet werden kann (Einschmelzverfahren

Um vor dem Einschmelzen ein Anhaften des Granulats am Substrat zu erzielen, wird eine Vorrichtung mit einem Elektrisierelement, das einen elektrischen Fotoleiter und ein elektrisches Leitelement umfasst, einer Elektrisiervorrichtung zum elektrostatischen Aufladen des Elektrisierelements, einer Lichtquelle zum örtlichen selektiven Entladen des Elektrisierelements, einer Depositionseinrichtung zum Aufbringen eines elektrischen Leiters (des Granulats) und einer Aufbringeinrichtung zum Aufbringen eines flächigen Substrats auf das Elektrisierelement verwendet.

Diese Vorgehensweise führt zu einer erhöhten Genauigkeit der Positionierung und Formgebung des mindestens einen Schaltungsteils auf dem Substrat. Es sind Genauigkeiten weit unter 1 mm erreichbar. Im Ergebnis können verringerte Mindestbreiten und Mindestabstände von Schaltungsteilen realisiert werden. Zudem kann das Verfahren sehr schnell durchgeführt werden. Es eignet sich insbesondere für das Rapid-Prototyping, d.h. für das schnelle Herstellen von Schaltungen in Kleinserie. Auch kann auf nasschemische Prozesse verzichtet werden. Es fallen damit keine zu entsorgenden Reststoffe an.

Der Erfindung liegt gemäß einem ersten Gesichtspunkt die Aufgabe zugrunde, ein Laserdruckverfahren der eingangs genannten Art zu schaffen, bei dem eine gute Haftung des Granulates am Substrat erzielt wird, ohne dass es zu einer Beeinträchtigung der Eigenschaften des Substrates kommt.

Zur Lösung dieser Aufgabe sieht die Erfindung die im Anspruch 1 zusammengefassten Merkmale vor.

In der vorliegenden Beschreibung wird mit "Deponieren" eines Granulats allgemein die Anordnung des Granulats, insbesondere das Aufstreuen, das Aufbringen durch elektrostatisch ungleiches Aufladen von Granulat und Substrat bezeichnet. Das Deponieren des Granulats erfolgt derart, dass eine vorbestimmte Flächenbedeckung (Granulatmasse pro Flächeneinheit) des Substrats erzielt wird. Die Flächenbedeckung wird so gewählt, dass die so genannte Perkolationsschwelle überschritten wird.

Diese Bedingung ist erfüllt, wenn die Flächenbedeckung ausreichend hoch ist, so dass ein elektrischer Strom durch das auf dem Substrat deponierte Granulat fließen kann, wie es durch einfache Versuche mit den konkret verwendeten Materialien feststellbar ist.

Mit dem Begriff "Granulat" (oder: "Pulver") wird allgemein ein rieselfähiges Korngemenge bezeichnet, dessen Kornform und Korngröße in Abhängigkeit von der konkreten Anwendung gewählt wird. Das Granulat umfasst als elektrisch leitfähiges Material einen Leiter, wie z.B. Kupfer, Nickel, Silber, Aluminium, eine Kupfer-Zinn-Legierung oder einen leitfähigen Kunststoff, oder einen Halbleiter, wie z. B. dotiertes Silizium oder einen organischen Halbleiter. Die Verwendung der Kupfer-Zinn-Legierung hat den Vorteil, dass der Schmelzpunkt in Abhängigkeit vom Zinnanteil einstellbar ist.

Das Granulat kann aus einem elektrisch leitfähigen Material oder aus einem Verbundmaterial bestehen, bei dem die einzelnen Körner einen Kern aus dem elektrisch leitfähigen Material und eine Verkapselung aufweisen. Die Verkapselung kann aus einem elektrisch isolierenden, thermisch zersetzbaren Material (Zerfallstemperatur vorzugsweise unter 300°C) oder einem weiteren elektrisch leitfähigen Material (z.B. Kupfer auf einem Kern aus Aluminium) bestehen. Das Verbundmaterial kann durch Dampfabscheidung der Verkapselung auf den Kernen hergestellt werden, zum Beispiel indem die Kerne gekühlt durch einen erhitzten Nebel des gewünschten Verkapselungsmaterials rieseln.

Typischerweise kann die mit an sich bekannten Verfahren messbare Korngröße des erfindungsgemäß verwendeten Granulats maximal 1 mm, vorzugsweise maximal 500 µm, besonders bevorzugt maximal 300 µm betragen. Als Untergrenze der Korngröße wird typischerweise mindestens 1 µm, vorzugsweise mindestens 50 µm, besonders bevorzugt mindestens 100 µm gewählt.

Das Granulat kann insbesondere dadurch erhitzt werden, dass es zusammen mit dem Substrat erwärmt wird. Alternativ kann das Substrat und/oder das Granulat durch hochfrequente elektrische Wechselfelder oder durch die Absorption von Licht geeigneter Wellenlänge, insbesondere von Laserlicht erhitzt werden.

Gemäß der Erfindung wird also ein Folien-Mehrschichtaufbau aus zwei Kunststofffolien verwendet, von denen die eine einen Träger und die andere eine Einschmelzschicht bildet, die aus einem thermoplastischen Material besteht, in welches das Granulat eingeschmolzen wird. Die Erweichungstemperatur des Trägers ist vorzugsweise höher als die der Einschmelzschicht.

Der Folien-Mehrschichtaufbau kann vorteilhafterweise derart verwendet werden, dass er auf eine Temperatur gebracht wird, bei der die Einschmelzschicht bereits die Erweichungstemperatur erreicht hat, der Träger jedoch nicht. Das Granulat wird dann auf der Einschmelzschicht deponiert. Aufgrund von deren Erweichung geht das Granulat schnell eine innige Verbindung mit der Einschmelzschicht ein und haftet an ihr. Da der Träger seine Erweichungstemperatur noch nicht erreicht hat, wird die Handhabung durch die erhöhte Temperatur der Folie als Ganzes nicht behindert.

Die Kunststoffwahl erfolgt in Abhängigkeit von der konkreten Realisierung der Erfindung, insbesondere in Abhängigkeit von den gewünschten Schmelz- oder Zersetzungstemperaturen, und der weiteren Anwendung der erfindungsgemäß hergestellten Platine, insbesondere unter Beachtung von deren Stabilität bei typischen Löt- und Reflowtemperaturen von bis zu 310 °C. Die Schmelz- oder Zersetzungstemperaturen sind mit an sich bekannten Verfahren messbar. Beim Einschmelzverfahren wird als Träger bevorzugt ein Duroplast mit einem Zersetzungspunkt von über 360 °C oder ein Thermoplast, dessen Schmelzpunkt höher als 360°C ist, und als Einschmelzschicht ein Kunststoff mit einem Schmelzpunkt von annähernd 300 °C bis 320 °C verwendet. Besonders bevorzugt ist der Kunststoff ein Olefin, Polymethylmethacrylat (PMMA) oder Polyetherketon (PEK), insbesondere Polyetheretherketon (PEEK)

Ein weiterer wichtiger Vorteil der Erfindung besteht in der Variabilität der Arten der auf dem Substrat herstellbaren Schaltungsteile. So können gemäß einer bevorzugten Ausführungsform der Erfindung das Material und die geometrische Verteilung des deponierten Granulats so gewählt werden, dass das Schaltungsteil auf dem Substrat mindestens eine Leiterbahn bildet. Vorzugsweise wird eine vorbestimmte Leiterstruktur gebildet, wie es bei der Herstellung gedruckter Schaltungen vorgesehen ist.

Gemäß einer abgewandelten Ausführungsform der Erfindung können das Material und die geometrische Verteilung des deponierten Granulats so gewählt werden, dass das Schaltungsteil auf dem Substrat mindestens ein Bauelement einer elektrischen Schaltung bildet. Das Bauelement kann ein aktives Halbleiterbauelement, wie z. B. eine Diode oder ein Transistor oder ein passives Bauelement, wie z. B. ein Widerstand sein. Widerstände können z. B. durch die Auswahl eines vorbestimmten Materials, wie z. B. Kohlenstoff, und oder einer vorbestimmten Flächenbedeckung des Granulats erzeugt werden.

Vorteilhafterweise kann eine komplette elektrische Schaltung hergestellt werden, indem verschiedene Granulate deponiert werden, die nach dem Erhitzen auf dem Substrat Schaltungsteile mit mindestens einer Leiterbahn und mindestens einem aktiven oder passiven Bauteil bilden. Hierzu wird der Schritt des Deponierens mit den verschiedenen Granulaten in Teilschritten wiederholt. Zwischen den Teilschritten kann jeweils ein Erhitzen zur Bildung der entsprechenden Schaltungsteile vorgesehen sein. Bevorzugt ist jedoch eine Ausführungsform, bei der die Teilschritte unmittelbar aufeinander folgend vor einem einzigen Erhitzen vorgesehen sind.

In einem bevorzugten Verfahren wird das Erhitzen des Granulats mit einer Druckausübung kombiniert. Zu diesem Zweck ist ein Überwalzen mit einer Walze vorgesehen. Diese Walze weist vorzugsweise eine Temperatur auf, die so hoch gewählt ist, dass das Granulat aufschmilzt und in das Substrat einsinken kann. Beim Überwalzen mit einer Walze wird ausgenutzt, dass durch die heiße Walze die erste Kunststofffolie des Substrats erweicht. Durch den zusätzlichen mechanischen Druck auf das Granulat wird das Granulat in das Substrat gedrückt und geht dort mit dem Substrat eine innige Verbindung ein. Dabei bleibt die Leitfähigkeit des Schaltungsteils erhalten.

Da es sich bei dem erfindungsgemäßen Verfahren um ein Laserdruckverfahren handelt, wird das Granulat vorzugsweise aus einem Vorratsbehälter (Kartusche) auf das Substrat übertragen und dort gebunden, wie es bei einem Laserdrucker zur Bildung eines Druckbildes mit einem Toner vorgesehen ist. Falls der Schritt des Deponierens mit verschiedenen Granulaten in Teilschritten wiederholt wird, können die Granulate wie bei einem Farblaserdrucker in getrennten Vorratsbehältern vorgesehen und aufeinanderfolgend auf das Substrat aufgebracht werden.

Vorzugsweise erfolgen insbesondere die Schritte des Aufladens, bei dem das Granulat und das Substrat relativ zueinander entgegengesetzt elektrostatisch aufgeladen werden, und des Zusammenbringens von Granulat und Substrat, so dass sich das Granulat entlang der gewünschten geometrischen Verteilung des Granulats, z. B. der gewünschten Leiterbahnstruktur auf dem Substrat anordnet.

Die geometrische Verteilung wird dem Granulat oder dem Substrat beim Aufladen aufgeprägt. Im ersten Fall wird eine lichtempfindliche Walze elektrostatisch aufgeladen. Diese Walze wird mittels einer LED oder einem Laser in Abhängigkeit von der gewünschten geometrischen Verteilung belichtet. An den nicht belichteten Stellen wirkt die Aufladung, so dass sich das Granulat entsprechend dem geschriebenen Bild der Verteilung anordnet. Durch eine Gegenladung wird dieses Granulat dann von der Walze auf das Substrat gezogen. Im zweiten Fall wird die Ladung mit der geometrischen Verteilung von der belichteten Walze auf das Substrat übertragen.

Vorzugsweise umfasst der Schritt des Aufladens des Substrats ein elektrostatisches Aufladen eines Elektrisierelements, das einen elektrischen Fotoleiter umfasst, der in Kontakt mit einem elektrischen Leitelement steht und anschließend selektives Belichten des Elektrisierelements, so dass an den belichteten Stellen der Fotoleiter elektrisch leitend wird und die elektrostatische Aufladung über den Kontakt mit dem elektrischen Leiter abgebaut wird. Dazu ist das elektrische Leitelement vorzugsweise geerdet. Nach dem selektiven Belichten wird die elektrostatische Aufladung auf das Substrat übertragen. Dies geschieht beispielsweise durch in Kontakt bringen von Elektrisierelement und Substrat. Dieses Verfahren ist besonders geeignet für unflexible Substrate.

Bei einer alternativen Ausführungsform wird vor dem Zusammenbringen von elektrostatisch aufgeladenem Granulat und elektrostatisch aufgeladenem Substrat das Substrat auf dem Elektrisierelement positioniert. In diesem Fall befindet sich die elektrische Ladung zwischen dem Elektrisierelement und dem Substrat. Aufgrund einer Polarisation des Substrats entsteht dabei ein elektrisches Feld zwischen der dem Elektrisierelement abgewandten Seite des Substrats und dessen Umgebung. Aufgrund dieses Feldes wird das elektrostatisch aufgeladene Granulat von den Stellen elektrostatisch angezogen, die den aufgeladenen Stellen des Elektrisierelements gegenüberliegen.

Gemäß einer weiteren Ausführungsform der Erfindung kann die Folie, die als Substrat dient, eine fotoleitende Schicht enthalten, so dass das Substrat direkt elektrostatisch aufgeladen und mittels einer LED oder eines Lasers beschrieben werden kann.

Gemäß einer weiteren Abwandlung des erfindungsgemäßen Verfahrens kann vor dem Erhitzen des Granulats eine Deckfolie auf das Substrat mit dem darauf deponierten Granulat gelegt werden, so dass sich das Granulat zwischen dem Substrat und der Deckfolie befindet. Diese Ausführungsform ist insbesondere bei der Herstellung kompletter Schaltungen von Vorteil, die mit der Deckfolie einen Schutz erhalten. Wenn die Folie einen Träger und eine Schmelzschicht mit unterschiedlichen Erweichungstemperaturen aufweist, wird die Deckfolie vorzugsweise so gewählt, dass ihre Erweichungstemperatur der des Trägers entspricht. Beim Erwärmen des Folienverbunds erweicht zunächst die Schmelzschicht. Das Granulat verbindet sich mit der Schmelzschicht, und die gebildeten Schaltungsteile werden einerseits durch den Träger und andererseits durch die Deckfolie abgedeckt.

Nach dem Herstellen eines Substrats mit mindestens einem Schaltungsteil können beim erfindungsgemäßen Verfahren noch weitere Schritte vorgesehen sein, die vorzugsweise eine Bestückung des Substrates mit Bauelementen und/oder eine Bearbeitung des Substrates, wie z. B. eine Rand- oder Oberflächenbearbeitung, die Anbringung von Kontaktierungslöchern oder die Fixierung auf einer zusätzlichen festen Trägerplatte umfassen.

Gemäß einer besonders vorteilhaften Variante der Erfindung können des weiteren mehrere (mindestens zwei) Substrate, wie z. B. Leiterbahnfolien mit Bauteilen, zu einem Kompositbauteil verbunden werden. Mit dem Begriff "Kompositbauteil" wird hier eine mehrschichtige Platine bezeichnet, die mindestens zwei übereinander angeordnete Substrate jeweils mit mindestens einem Schaltungsteil umfasst. Das Kompositbauteil kann zusätzlich eine Trägerplatte enthalten. Des weiteren kann das Kompositbauteil zur Vervollständigung der eigenen Funktionsfähigkeit mit vorbestimmten elektrischen Verbindungen, z. B. Löt- und/oder Drahtverbindungen zwischen den Schaltungsteilen auf den verschiedenen Substraten ausgestattet werden. In Abhängigkeit von den miteinander kombinierten Schaltungsteilen oder Schaltungen können im Kompositbauteil mit großer Flexibilität verschiedene Schaltungsfunktionen realisiert werden.

Im Folgenden wird die Erfindung anhand der beigefügten Zeichnung erläutert. Dabei zeigt
- Figur 1: eine erfindungsgemäße Vorrichtung zur Herstellung von-Schaltungsteilen auf einem Substrat,
- Figur 2: eine schematische Schnittansicht eines erfindungsgemäß verwendeten Folien-Mehrschichtaufbau, und
- Figur 3: den Folien-Mehrschichtaufbau nach Figur 2 nach dem Abdecken mit einer Abdeckfolie und einem Überwalzen mit einer heißen Walze, ebenfalls in einer schematischen Schnittansicht.

Die Erfindung wird im folgenden unter Bezug auf die Anwendung des Laserdruckverfahrens bei der Herstellung von Schaltungsteilen auf einem Substrat beschrieben. Einzelheiten der Schaltungstechnik, wie z. B. die Auswahl der Form und Anordnung der Schaltungsteile, sind an sich von der herkömmlichen Technik zur Herstellung gedruckter Schaltungen bekannt und werden daher hier nicht näher beschrieben. Einzelheiten der Ansteuerung der bildgebenden Einheit eines Laserdruckers zur Bereitstellung einer bestimmten geometrischen Verteilung des Granulats, sind ebenfalls von der herkömmlichen Laserdrucktechnik bekannt und werden daher hier nicht näher beschrieben.

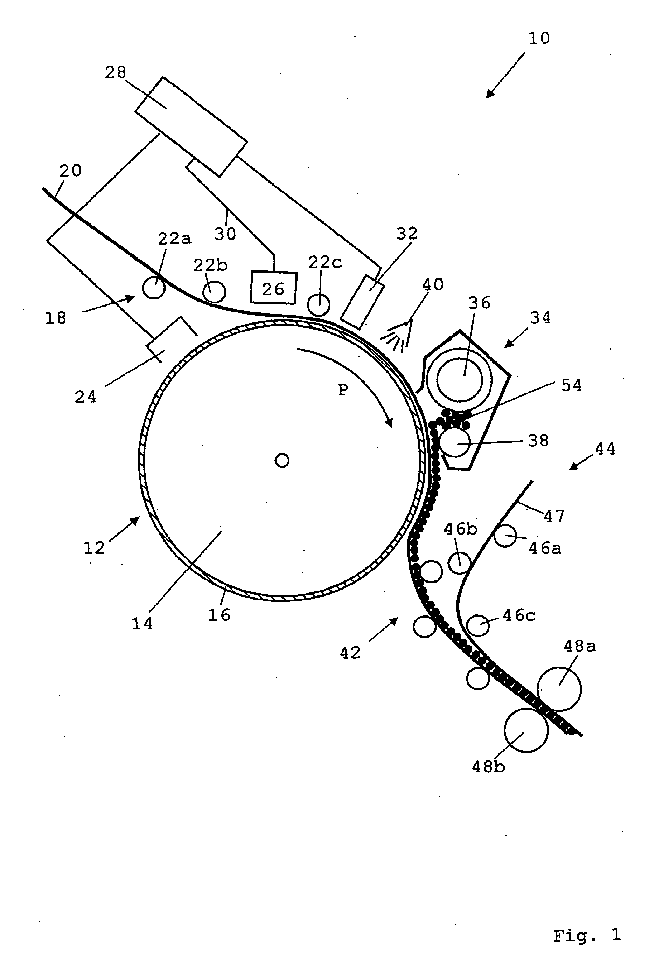

Figur 1 zeigt eine schematische Zeichnung einer erfindungsgemäßen Vorrichtung 10 zur Herstellung von Schaltungsteilen auf einem Substrat. Die Vorrichtung 10 umfasst ein Elektrisierelement in Form einer Fotoleitertrommel 12, die einen elektrisch leitfähigen, geerdeten, zylinderförmigen Grundkörper 14 und einen auf dem Grundkörper 14 aufgebrachten Fotoleiter 16 umfasst. Der Fotoleiter umfasst amorphe organische Halbleiter, amorphes Silizium oder Arsentriselenid (As₂Se₃). Die Fotoleitertrommel 12 ist um die Zylinderachse des Grundkörpers 14 drehbar gelagert (Drehrichtung siehe Pfeil P). Die Vorrichtung 10 ist in einem lichtdichten Gehäuse (nicht gezeigt) angeordnet.

Die Vorrichtung 10 umfasst ein Aufbringmittel 18 zum Aufbringen eines flächigen Substrats in Form einer Kunststofffolie 20 auf die Fotoleitertrommel 12. Das Aufbringmittel 18 umfasst dabei drei Walzen 22a, 22b und 22c, die so um die Leitertrommel 12 angeordnet sind, dass die Kunststofffolie 20 an die Oberfläche der Fotoleitertrommel 12 gedrückt wird. In Drehrichtung der Fotoleitertrommel 12 vor dem Ort, an dem die Kunststofffolie 20 auf die Fotoleitertrommel 12 trifft, befindet sich ein Ladekorotron 24, das die Oberfläche der Fotoleitertrommel 12 durch eine Koronarentladung elektrostatisch auflädt.

In Drehrichtung hinter dem Ladekorotron 24 befindet sich ein Zeichengenerator 26, der mehrere Leuchtdioden (LEDs) umfasst. Der Zeichengenerator 26 ist mit einer Steuerung 28 über eine elektrische Leitung 30 verbunden. Im Betrieb steuert die Steuerung 28 den Zeichengenerator 26 an, um den Fotoleiter 16 auf der Fotoleitertrommel 12 gemäß einer in der Steuerung gespeicherten Schaltungsstruktur, z. B. Leiterbahnstruktur örtlich selektiv durch ein für das Licht des Zeichengenerators 26 transparentes Substrat zu belichten. Dadurch wird der Fotoleiter 16 leitend und die elektrische Ladung, die sich auf der Oberfläche der Fotoleitertrommel 12 befindet, fließt durch den geerdeten Grundkörper 14 ab. Sofern das Substrat nicht hinreichend transparent ist, befindet sich der Zeichengenerator 26 in Drehrichtung vor dem Punkt, an dem das Substrat auf die Fotoleittrommel trifft. In Drehrichtung nach dem Zeichengenerator 26 befinden sich daher elektrische Ladungen nur noch zwischen der Fotoleitertrommel 12 und der Kunststofffolie 20 an den Orten, die nicht durch den Zeichengenerator 26 beleuchtet worden sind. Diese Ladungsverteilung entspricht der gewünschten Verteilung des auf dem Substrat abzuscheidenden Granulats.

In Drehrichtung hinter dem Zeichengenerator 26 befindet sich ein Potenzialsensor 32, welcher der Überwachung des Schreibvorgangs des Zeichengenerators dient. In Drehrichtung hinter dem Potenzialsensor 32 befindet sich eine Granulatkartusche 34, die einen Granulatbehälter 36 (Vorratsbehälter) und eine Aufbringwalze 38 umfasst. Im Granulatbehälter 36 ist Kupferpulver enthalten.

Granulat 54 aus dem Granulatbehälter 36 wird in einer gleichmäßigen dünnen Schicht auf die Aufbringwalze 38 aufgebracht und dort elektrostatisch aufgeladen. Aufgrund der elektrostatischen Anziehungskraft zwischen den Stellen, auf denen sich auf der Fotoleitertrommel 12 elektrische Ladungen befinden und mit entgegengesetzter Polarität aufgeladenen Körnern des Granulats 54 werden die Körner auf die entsprechenden Stellen auf der Fotoleitertrommel hin beschleunigt und haften dort an der Kunststofffolie 20 an. Dadurch wird Granulat 54 eines leitfähigen Materials auf einen durch Wärme erweichbaren Nichtleiter als Substrat gemäß der gewünschten geometrischen Verteilung (z. B. Leiterbahnstruktur oder Struktur eines Bauelements) deponiert. Die von dem Ladekoroton 24 und der Aufbringwalze 38 jeweils aufgebrachte elektrische Ladung ist so gewählt, dass die Flächenbedeckung der Folie 20 mit dem Granulat 54 oberhalb der Perkolationsschwelle liegt. Dadurch ist nach dem Durchlauf der Folie 20 durch die Vorrichtung 10 die entstandene Leiterbahn elektrisch leitfähig.

Um die Anhaftung der Körner des Granulats 54 zu erhöhen, befindet sich in Drehrichtung vor der Granulatkartusche 34 eine Heizvorrichtung 40. Diese erwärmt den radial außen liegenden Bereich der Kunststofffolie 20 so, dass er erweicht und damit eine bessere Haftung gegenüber den Kupferkörnern des Granulats 54) aufweist.

In einer alternativen Ausführungsform wird die Haftneigung der Kunststofffolie 20 durch Aufbringen eines dünnen Films eines Öls oder eines organischen Lösungsmittels erhöht.

In Drehrichtung hinter der Granulatkartusche 34 befindet sich eine Abnahmevorrichtung 42, die die Kunststofffolie 20 von der Fotoleitertrommel 12 abnimmt und von ihr wegleitet. Über eine Zuführung 44, die drei Zuführwalzen 46a, 46b und 46c umfasst, kann optional eine Deckfolie 47 auf die Kunststofffolie 20 befördert und auf dieser positioniert werden. Hinter der Zuführung 44 befinden sich zwei Heizwalzen 48a und 48b, die die Kunststofffolie 20 und die Deckfolie 47 so weit erhitzen, dass beide fest miteinander verbunden werden und das Granulat 54 zwischen sich einschließen.

Durch die Heizwalzen 48a, 48b wird das Granulat 54 so erhitzt, dass es mit der Kunststofffolie 20 eine dauerhafte Verbindung eingeht und eine elektrisch leitfähige Leiterbahn bildet.

In einem weiteren alternativen Verfahren wird anstelle eines Kupfergranulats ein Granulat aus einer niedrig schmelzenden Legierung verwendet, die einen Schmelzpunkt von unter 200°C, insbesondere unter 150°C, insbesondere unter 130°C aufweist. Aufgrund der Hitze der Heizwalzen schmilzt dieses Granulat auf und bildet eine durchgehende Leiterbahn.

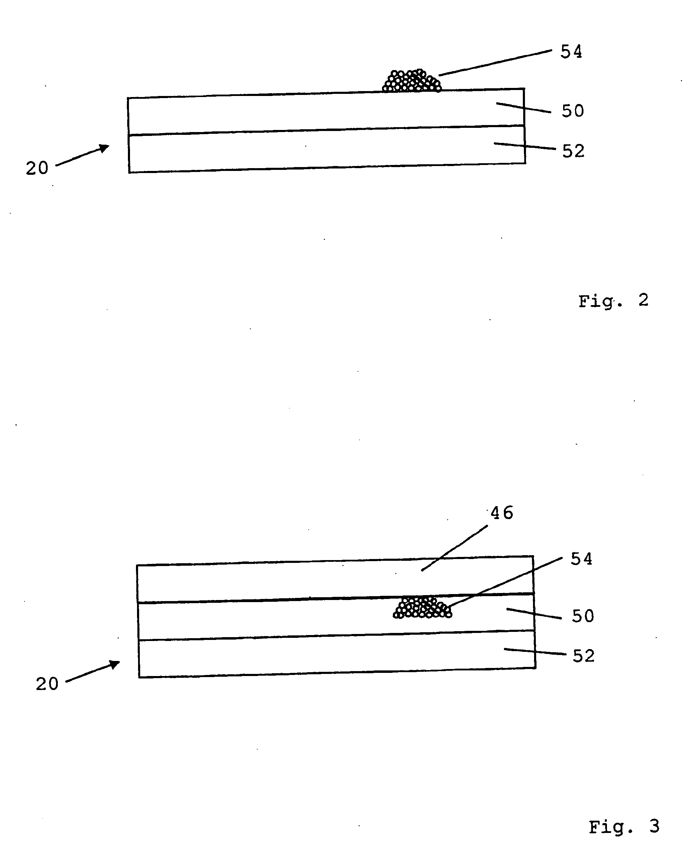

Figur 2 zeigt den Mehrschicht-Aufbau der Kunststofffolie 20. Die Kunststofffolie 20 umfasst eine erste Kunststofffolie 50 als Einschmelzschicht und eine zweite Kunststofffolie 52 als Träger. Beide Kunststofffolien bestehen aus Thermoplasten. Die erste Kunststofffolie 50 besteht aus Polyethylen, die zweite Kunststofffolie 52 aus Polymethylmethacrylat (PMME). In Figur 2 ist der Zustand hinter der Granulatkartusche 34 und vor der Zuführung 44 gezeigt. Auf der Oberfläche der ersten Kunststofffolie 50 haftet Granulat 54 an, das aus Kupferkörnern besteht.

In einem alternativen Verfahren wird als zweite Kunststofffolie Polyetherketon (Kurzzeichen PEK) eingesetzt, insbesondere Polyetheretherketon (PEEK).

Figur 3 zeigt einen Verbund aus der Kunststofffolie 20 und der optional vorgesehenen Deckfolie 47, nachdem die Heizwalzen 48a, 48b passiert worden sind. Das Granulat 54 ist aufgrund der zwischenzeitlichen Erwärmung in die erste Kunststofffolie 50 eingesunken und bildet dort eine Leiterbahn.

Das Verfahren kann mehrfach ausgeführt werden. Die dabei entstehenden Leiterbahnen auf den entsprechenden Substraten werden in einem weitergebildeten Verfahren zu einem Stapel übereinander gelegt, so dass mehrere Lagen an Substraten entstehen. Die Leiterbahnen auf den jeweiligen Substraten der Lagen sind dann an den vorgesehenen Stellen aufgrund des Übereinanderliegens, das heißt aufgrund des physischen Kontakts, miteinander elektrisch leitend verbunden. Es können so integrierte Bauteile hergestellt werden, so dass eine nachträgliche Bestückung entfallen kann.

Durch das Übereinanderlegen von mehreren Lagen ist zudem möglich, elektrische Bauelemente auszubilden, die sich in einer Richtung erstrecken, die nicht der Ausdehnung des Substrats entspricht. So ist es möglich, zwei elektrische, zu einer plattenförmigen Struktur erweiterte Leiterbahnen durch eine Lage Substrat zu trennen, so dass ein Kondensator entsteht.

Durch gezielte Wahl der Flächenbedeckung des Granulats können Widerstände erzeugt werden. Je geringer die Flächenbedeckung gewählt ist, desto höher ist der elektrische Widerstand. Durch Variation der Flächenbedeckung wird dabei diejenige Flächenbedeckung ermittelt, die dem gewünschten Widerstand entspricht.

Es ist in einem erfindungsgemäßen Verfahren auch möglich, nacheinander Granulate verschiedener elektrischer Leiter oder Halbleiter aufzubringen. Zum Bilden einer Diode oder eines Transistors werden Granulate unterschiedlich dotierte Halbleiter verwendet, wie beispielsweise p- und n-dotiertes Silizium.

## Patentansprüche

1. Laserdruckverfahren zum Herstellen mindestens eines Schaltungsteils auf einem aus Kunststoff hergestellten Substrat (20), das folgende Schritte umfasst:
(a) Deponieren mindestens eines Granulats (54), das einen elektrischen Leiter enthält, mit einer vorbestimmten geometrischen Flächendeckung auf dem Substrat (20), und
(b) Erhitzen des Granulats (54), wobei das Granulat (54) eine dauerhafte Verbindung mit dem Substrat (20) eingeht und das mindestens eine Schaltungsteil auf dem Substrat (20) bildet,
**dadurch gekennzeichnet, dass** als Substrat ein Folien-Mehrschichtaufbau (20) mit einer ersten Kunststofffolie (50) und einer zweiten Kunststofffolie (52) verwendet wird, wobei die erste Kunststofffolie (50) eine geringere Erweichungstemperatur hat als die zweite Kunststofffolie (52).

2. Laserdruckverfahren nach Anspruch 1, **dadurch gekennzeichnet, dass** die geometrische Verteilung des mindestens einen Granulats (54) so gewählt ist, dass das Schaltungsteil auf dem Substrat (20) mindestens eine Leiterbahn bildet.

3. Laserdruckverfahren nach Anspruch 1 oder 2, **dadurch gekennzeichnet, dass** die geometrische Verteilung des mindestens einen Granulats (54) so gewählt ist, dass das Schaltungsteil auf dem Substrat (20) mindestens ein aktives oder passives Bauelement bildet.

4. Laserdruckverfahren nach einem der vorstehenden Ansprüche, **dadurch gekennzeichnet, dass** das Erhitzen des mindestens einen Granulats (54) durch Überwalzen mit einer Heizwalze (48a, 48b) erfolgt.

5. Laserdruckverfahren nach einem der vorstehenden Ansprüche, **dadurch gekennzeichnet, dass** das Erhitzen des mindestens einen Granulats (54) auf eine Temperatur vorgesehen ist, bei der das Granulat (54) überwiegend in das Substrat (20) einsinkt und/oder mit der Oberfläche des Substrats (20) eine Verbindung eingeht.

6. Laserdruckverfahren nach einem der vorstehenden Ansprüche, **dadurch gekennzeichnet, dass** das Deponieren des mindestens einen Granulats (54) die Schritte umfasst:
- elektrostatisches Aufladen des mindestens einen Granulats (54),
- elektrostatisches Aufladen des Substrats (20) in einem Teilbereich, welcher der vorbestimmten geometrischen Verteilung entspricht, und
- Zusammenbringen von elektrostatisch aufgeladenem Granulat (54) und elektrostatisch aufgeladenem Substrat (20), so dass sich das Granulat entsprechend der vorbestimmten geometrischen Verteilung auf dem Substrat (20) anordnet.

7. Laserdruckverfahren nach Anspruch 6, **dadurch gekennzeichnet, dass** der Schritt des Aufladens des Substrats umfasst:
- elektrostatisches Aufladen eines Elektrisierelements (12), das einen elektrischen Fotoleiter (16) umfasst, der in Kontakt mit einem elektrischen Leitelement (14) steht,
- selektives Belichten des Elektrisierelements (12), so dass an den belichteten Stellen der Fotoleiter (16) elektrisch leitend wird und die elektrostatische Aufladung über den Kontakt mit dem elektrischen Leitelement (14) abgebaut wird, und
- Übertragen der elektrostatischen Aufladung vom Elektrisierelement (12) auf das Substrat (20)

8. Laserdruckverfahren nach einem der vorstehenden Ansprüche, **dadurch gekennzeichnet, dass** vor Schritt (a) als zusätzlicher Schritt vorgesehen ist:
- Erwärmen des Substrats (20) auf eine Temperatur, bei der das Granulat (54) am Substrat (20) inhärent und ohne elektrostatische Aufladung anhaftet.

9. Laserdruckverfahren nach einem der vorstehenden Ansprüche, **gekennzeichnet durch** den weiteren Schritt:
- Bestückung des Substrates mit weiteren Bauelementen.

10. Laserdruckverfahren zum Herstellen eines elektrischen Kompositbauteils, mit den Schritten:
- Herstellen von Schaltungsteilen auf mehreren Substraten mit einem Verfahren nach einem der vorstehenden Ansprüche, und
- Verbinden der Substrate zu dem Kompositbauteil.

11. Laserdruckverfahren nach Anspruch 10, **gekennzeichnet durch** den weiteren Schritt:
- Herstellen von vorbestimmten elektrischen Verbindungen zwischen den Schaltungsteilen auf den Substraten.

12. Platine, umfassend mindestens ein Substrat, auf dem mindestens ein Schaltungsteil angeordnet ist, **dadurch gekennzeichnet, dass** das mindestens eine Schaltungsteil nach einem der vorhergehenden Ansprüche hergestellt ist.

13. Kompositbauteil, umfassend einen Verbund von mehreren Platinen nach Anspruch 12.

## Claims

1. A laser printing method for the production of at least one circuit portion on a substrate (20) made from a plastic material, said method comprising the following steps:
(a) depositing at least one granular material (54) which includes an electrical conductor with a predetermined geometrical distribution on the substrate (20), and
(b) heating the granular material (54), in which case the granular material (54) provides a permanent join to the substrate (20) and forms the at least one circuit portion on the substrate (20),
**characterized in that** a film multilayer structure (20) having a first plastic film (50) and a second plastic film (52) is used as the substrate, wherein the first plastic film (50) has a lower softening temperature than the second plastic film (52).

2. A laser printing method as set forth in claim 1 **characterized in that** the geometrical distribution of the at least one granular material (54) is so selected that the circuit portion on the substrate (20) forms at least one conductor track.

3. A laser printing method as set forth in claim 1 or claim 2 **characterized in that** the geometrical distribution of the at least one granular material (54) is so selected that the circuit portion on the substrate (20) forms at least one active or passive component.

4. A laser printing method as set forth in one of the preceding claims **characterized in that** heating of the at least one granular material (54) is effected by rolling over with a heating roller (48a, 48b).

5. A laser printing method as set forth in one of the preceding claims **characterized in that** the at least one granular material (54) is heated to a temperature at which the granular material (54) predominantly sinks into the substrate (20) and/or provides a connection to the surface of the substrate (20).

6. A laser printing method as set forth in one of the preceding claims **characterized in that** the operation of depositing the at least one granular material (54) includes the following steps:
- electrostatically charging the at least one granular material (54),
- electrostatically charging the substrate (20) in a subregion which corresponds to the predetermined geometrical distribution, and
- bringing together the electrostatically charged granular material (54) and the electrostatically charged substrate (20) so that the granular material is arranged on the substrate (20) in accordance with the predetermined geometrical distribution.

7. A laser printing method as Set forth in claim 6 **characterized in that** the substrate charging step includes:
- electrostatically charging an electrization element (12) which includes an electrical photoconductor (16) which is in contact with an electrical conducting element (14),
- selectively exposing the electrization element (12) so that at the exposed locations the photoconductor (16) becomes electrically conducting and the electrostatic charge is removed by way of the contact with the electrical conducting element (14), and
- transferring the electrostatic charge from the electrization element (12) onto the substrate (20).

8. A laser printing method as set forth in one of the preceding claims **characterized in that** prior to step (a) the following additional step is provided:
- heating the substrate (20) to a temperature at which the granular material (54) adheres to the substrate (20) inherently and without electrostatic charging.

9. A laser printing method as set forth in one of the preceding claims **characterized by** the further step:
- equipping the substrate with further components.

10. A laser printing method for the production of an electrical composite component comprising the steps:
- producing circuit portions on a plurality of substrates with a process as set forth in one of the preceding claims, and
- joining the substrates to afford the composite component.

11. A laser printing method as set forth in claim 10 **characterized by** the further step:
- producing predetermined electrical connections between the circuit portions on the substrates.

12. A circuit board including at least one substrate on which at least one circuit portion is arranged **characterized in that** the at least one circuit portion is produced according to any one of the preceding claims.

13. A composite component comprising a composite array of a plurality of circuit boards as set forth in claim 12.

## Revendications

1. Procédé d'impression laser pour la fabrication d'au moins une pièce de circuit sur un substrat (20) en matière plastique, comprenant les étapes suivantes :
(a) dépôt d'au moins un granulé (54) contenant un conducteur électrique, suivant une distribution géométrique déterminée sur le substrat (20), et
(b) chauffage du granulé (54), ledit granulé (54) entrant alors en liaison durable avec le substrat (20) et formant la ou les pièces de circuit sur le substrat (20),
**caractérisé en ce qu'**une structure à feuilles en plusieurs couches (20), avec une première feuille plastique (50) et une deuxième feuille plastique (52), est utilisée comme substrat, la première feuille plastique (50) présentant une température de ramollissement inférieure à la deuxième feuille plastique (52).

2. Procédé d'impression laser selon la revendication 1, **caractérisé en ce que** la distribution géométrique du ou des granulés (54) est choisie de telle manière que la pièce de circuit forme au moins une piste conductrice sur le substrat (20).

3. Procédé d'impression laser selon la revendication 1 ou la revendication 2, **caractérisé en ce que** la distribution géométrique du ou des granulés (54) est choisie de telle manière que la pièce de circuit forme au moins un composant actif ou passif sur le substrat (20).

4. Procédé d'impression laser selon l'une des revendications précédentes, **caractérisé en ce que** le chauffage du ou des granulés (54) est réalisé par surlaminage avec un cylindre chauffant (48a, 48b).

5. Procédé d"impression laser selon l'une des revendications précédentes, **caractérisé en ce que** le chauffage du ou des granulés (54) est prévu à une température où le granulé (54) s'enfonce pour l'essentiel dans le substrat (20) et/ou entre en liaison avec la surface du substrat (20).

6. Procédé d'impression laser selon l'une des revendications précédentes, **caractérisé en ce que** le dépôt du ou des granulés (54) comprend :
- la charge électrostatique du ou des granulés (54),
- la charge électrostatique du substrat (20) dans une zone partielle correspondant à la distribution géométrique déterminée, et
- l'assemblage du granulé (54) charge électrostatiquement et du substrat (20) charge électrostatiquement, de telle manière que le granulé se dispose suivant la distribution géométrique déterminée sur le substrat (20).

7. Procédé d'impression laser selon la revendication 6, **caractérisé en ce que** l'étape de charge du substrat comprend :
la charge électrostatique d'un élément d'électrisation (12) comprenant un photoconducteur électrique (16) en contact avec un élément conducteur électrique (14),
l'illumination sélective de l'élément d'électrisation (12), de manière à rendre le photoconducteur (16) électriquement conducteur aux endroits illuminés et à annuler la charge électrostatique via le contact avec l'élément conducteur électrique (14), et
- la transmission de la charge électrostatique de l'élément d'électrisation (12) au substrat (20).

8. Procédé d'impression laser selon l'une des revendications précédentes, **caractérisé en ce qu'**avant l'étape (a), il est prévu comme étape supplémentaire :
- le chauffage du substrat (20) à une température où le granulé (54) adhère au substrat (20) de manière inhérente et sans charge électrostatique.

9. Procédé d'impression laser selon l'une des revendications précédentes, **caractérisé par** l'étape supplémentaire :
- d'équipement du substrat avec d'autres composants.

10. Procédé d'impression laser pour la fabrication d'un composant électrique composite, comprenant les étapes :
- de fabrication de pièces de circuit sur plusieurs substrats au moyen d'un procédé d'impression laser selon l'une des revendications précédentes, et
- de liaison des substrats au composant composite.

11. Procédé d'impression laser selon la revendication 10, **caractérisé par** l'étape supplémentaire :
- de production de liaisons électriques définies entre les pièces de circuit sur les substrats.

12. Platine, comprenant au moins un substrat, sur lequel est disposée au moins une pièce de circuit, **caractérisé en ce que** la ou les pièces de circuit sont fabriquées selon l'une des revendications précédentes.

13. Composant composite, comprenant un assemblage de plusieurs platines selon la revendication 12.
